(19) Europäisches Patentamt
European Patent Office
Office européen des brevets

(11) Veröffentlichungsnummer: **0 391 901 B1**

(12) **EUROPÄISCHE PATENTSCHRIFT**

(45) Veröffentlichungstag der Patentschrift: **13.04.94**

(51) Int. Cl.[5]: **H01L 39/24**, C23C 16/00, C04B 35/00

(21) Anmeldenummer: **88907278.1**

(22) Anmeldetag: **24.08.88**

(86) Internationale Anmeldenummer:
**PCT/EP88/00758**

(87) Internationale Veröffentlichungsnummer:
**WO 89/03594 (20.04.89 89/09)**

(54) **VERFAHREN ZUR ABSCHEIDUNG VON SCHICHTEN AUS EINEM OXIDKERAMISCHEN SUPRALEITERMATERIAL AUF EINEM SUBSTRAT.**

(30) Priorität: **08.10.87 DE 3734069**

(43) Veröffentlichungstag der Anmeldung:
**17.10.90 Patentblatt 90/42**

(45) Bekanntmachung des Hinweises auf die Patenterteilung:
**13.04.94 Patentblatt 94/15**

(84) Benannte Vertragsstaaten:
**AT CH DE FR GB IT LI NL SE**

(56) Entgegenhaltungen:
**EP-A- 0 055 459**

**Advanced Ceramic Materials - Ceramic Superconductors, volume 2, No. 3B, July 1987, ACerS, (Westerville, Ohio, US), J.P. Kirkland et al.: "Thermal spraying superconducting oxide coatings", pages 401-410.**

**New Scientist, 14 April 1988, (London, GB), D. Bradley: "Metals with wings", pages 38-41.**

**Japanese Journal of Applied Physics, volume 26, No. 4, April 1987, (Tokyo, JP), S. Nagata et al.: "High Tc thin films of (La1.xMx)yCuo4-6 (M=Sr, Ba, Ca) prepared by sputtering", pages L410-L412.**

(73) Patentinhaber: **SIEMENS AKTIENGESELLSCHAFT**
**Wittelsbacherplatz 2**
**D-80333 München(DE)**

(72) Erfinder: **MÜLLER, Alfred**
**Fichtestr. 25**
**D-8520 Erlangen(DE)**

EP 0 391 901 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren zur Abscheidung mindestens einer Schicht aus einem oxidkeramischen Supraleitermaterial eines metallische Komponenten und Sauerstoff enthaltenden Stoffsystems mit hoher Sprungtemperatur auf einem Substrat.

Supraleitende Metalloxidverbindungen wie z.B. auf Basis des Stoffsystems Me1-Me2-Cu-O (Me 1 = Seltene Erden einschließlich Yttrium; Me 2 = Erdalkalimetalle) zeichnen sich durch hohe Sprungtemperaturen $T_c$ von beispielsweise etwa 40 K oder etwa 90 K aus. Aus diesen Materialien lassen sich z.B. Körper mit ausgeprägt drei-dimensionaler Gestalt, sogenanntes Bulk-Material, im allgemeinen auf pulvermetallurgischem Wege herstellen (vgl. z.B. "Zeitschrift für Physik B = Condensed Matter", Bd. 66, 1987, Seiten 141 bis 146 oder "Physical Review Letters", Vol. 58, No. 9, 2.3.1987, Seiten 908 bis 910). Neben der Ausbildung entsprechender Hoch-$T_c$-Supraleiter in Form von Bulk-Material ist besonders auch die Herstellung von dünnen Schichten oder Filmen bekannt. Hierzu dienen vielfach spezielle PVD (Physical Vapor Deposition)-Prozesse wie z.B. Aufdampfen oder Aufsputtern. Dabei wird im allgemeinen auf einem geeigneten Substrat oder Trägerkörper ein Vorprodukt aus den Komponenten der gewünschten Zusammensetzung mit einem Gefüge abgeschieden, das hinsichtlich der auszubildenden supraleitenden Metalloxidphase noch fehlstrukturiert ist. Dieses Vorprodukt wird anschließend durch eine im allgemeinen unter Sauerstoffzufuhr durchzuführende Glühbehandlung in das Material mit der gewünschten supraleitenden Phase überführt. Die hierbei vorzusehenden Glühtemperaturen liegen jedoch im allgemeinen sehr hoch, beispielsweise bei etwa 900 °C.

Die so zu erhaltenden supraleitenden Metalloxidphasen, deren Strukturen ähnlich der eines Perowskites sind, haben im Falle von $(La\text{-}Me2)_2CuO_{4-y}$ (mit ≧ 0) einen tetragonalen $K_2NiF_4$-Aufbau (vgl. z.B. "Japanese Journal of Applied Physics", Vol. 26, No. 2, Part 2 - Letters, Februar 1987, Seiten L123 und L124). Demgegenüber wird im Falle von $YBa_2Cu_3O_{7-x}$ (mit x ≧ 0) eine orthorhombische Struktur angenommen (vgl.z.B. "Europhysics Letters", Vol. 3, No. 12, 15.6.1987, Seiten 1301 bis 1307). Da die diese supraleitenden Phasen aufweisenden Materialien einer Oxidkeramik ähnlich sind, werden die entsprechenden Hoch-$T_c$-Supraleiter auch als oxidkeramische Supraleiter bezeichnet.

Mit den bekannten physikalischen Abscheideverfahren sind jedoch erhebliche Schwierigkeiten verbunden, kontinuierliche Schichten oder Filme in Form von Bandmaterial herzustellen. Außerdem sind die dem Abscheideprozeß nachzuschaltenden Wärmebehandlungen zur Ausbildung der gewünschten Kristall- und der Gefügestruktur, insbesondere aufgrund der hierfür vorzusehenden Temperaturen um 900 °C und höher, für viele Anwendungsfälle unerwünscht.

Ein spezielles physikalisches Abscheideverfahren, bei dem diese Schwierigkeiten auch gegeben sind, ist aus "Advanced Ceramic Materials", Vol. 2, No. 3B, Special Issue, 1987, Seiten 401 bis 410 zu entnehmen. Bei diesem bekannten Verfahren wird mittels Plasma-Spritzens oder Überschall-Flamm-Spritzens ein Metalloxid mit den Komponenten eines herzustellenden Supraleitermaterials auf ein Substrat aufgebracht. Auch hier ist eine anschließende Wärmebehandlung mit hohen Temperaturen zur Einstellung der gewünschten Kristallstruktur erforderlich.

Aus der EP-A-0 055 459 ist die Abscheidung von einfachen Metalloxiden und von sogenannten Doppeloxiden wie $Y_2O_3\text{-}ZrO_2$, auf einem erhitzten Substrat zu entnehmen. Hierzu ist ein sogenannter CVD-(Chemical Vapor Deposition)-Prozeß zugrundegelegt. Für diesen Abscheidungsprozeß wird von einem verdampfbaren $\beta$-Diketonat-Komplex jedes Metalls ausgegangen, dem Wasserdampf zugesetzt wird. Mit diesem Wasserdampf soll dann Sauerstoff in hinreichender Menge bereitgestellt werden, um so jede Metallkomponente oxidieren zu können. Das Dokument läßt nicht erkennen, inwieweit das bekannte CVD-Verfahren zur Herstellung so komplexer Systeme, wie es die vielkomponentigen oxidkeramischen Hoch-$T_c$-Supraleitermaterialien darstellen, geeignet ist, und ob insbesondere dabei die hohen Anforderungen an eine exakte Einhaltung der Stöchiometrie zu gewährleisten sind.

Aufgabe der vorliegenden Erfindung ist es, ein Verfahren anzugeben, das eine kontinuierliche Herstellung von Schichten oder Filmen aus einem vielkomponentigen supraleitenden Hoch-$T_c$-Material auf Substraten gestattet. Unter einem Substrat wird hierbei jeder beliebig strukturierte Körper verstanden, der eine Beschichtung mit dem genannten Material gestattet.

Diese Aufgabe wird erfindungsgemäß mit den im Kennzeichen des Hauptanspruchs angegebenen Verfahrensschritten gelöst.

Bei dem erfindungsgemäßen Verfahren handelt es sich somit um ein Verfahren nach Art an sich bekannter CVD-Prozesse. Die erfindungsgemäße Ausgestaltung der einzelnen Verfahrensschritte gestattet dabei einen kontinuierlich, in einer sauerstoffreichen Atmosphäre durchzuführenden Abscheideprozeß; es ist so möglich, Schichten aus der gewünschten supraleitenden Zusammensetzung und mit einer für eine hohe kritische Stromdichte hinreichend guten Textur insbesondere auch bei Temperaturen zu erzeugen, die

deutlich unter 900 °C liegen. Besondere Nachtemperungen unter Sauerstoffzufuhr zur Ausbildung der gewünschten Kristallstruktur sind also nicht erforderlich.

Vorteilhafte Ausgestaltungen des erfindungsgemäßen Verfahrens gehen aus den Unteransprüchen hervor.

Die Erfindung wird nachfolgend noch weiter erläutert, wobei auf die Zeichnung Bezug genommen wird, in deren Figur 1 schematisch der Ablauf zur Beschichtung von Substraten großer Länge mit einer supraleitenden Oxidkeramik gemäß der Erfindung angedeutet ist. In den Figuren 2 und 3 sind jeweils in einem Diagramm Dampfdruck-Temperatur-Kurven einzelner Ausgangskomponenten für das erfindungsgemäße Verfahren wiedergegeben. Figur 4 zeigt in Figur 1 entsprechender Darstellung ein weiteres Verfahrensschema für eine erfindungsgemäße Beschichtung eines Substrates.

Mit dem erfindungsgemäßen Verfahren sind ein- oder mehrlagige Schichten mit Schichtdicken bis über 10 µm aus bekannten supraleitenden Hoch-$T_c$-Materialien auf beliebig geformten Substraten (Trägerkörpern) auf chemischem Wege abzuscheiden. Die einzelnen Schichten bestehen somit aus einem Material, das einem Stoffsystem mit metallischen Komponenten und Sauerstoff zuzurechnen ist und dessen Sprungtemperatur insbesondere so hoch liegt, daß eine Kühlung mit flüssigem Stickstoff (77 K) ermöglicht ist. Zur Erläuterung der Erfindung sei das 4-komponentige Stoffsystem Me1-Me2-Cu-O ausgewählt. Das erfindungsgemäße Verfahren ist jedoch nicht nur auf dieses Stoffsystem beschränkt; d.h. es ist ebensogut auch für andere oxidkeramische, zumindest teilweise andere und/oder zusätzliche metallische Komponenten enthaltende Hoch-$T_c$-Supraleitermaterialien geeignet, die dem genannten 4-Stoffsystem nicht zuzurechnen sind. Bei dem zur Erläuterung der Erfindung ausgewählten Stoffsystem der Zusammensetzung Me1-Me2-Cu-O sind als Ausgangsmaterialien Me1 und Me2 aus der Gruppe der Seltenen Erdmetalle wie z.B. Y bzw. aus der Gruppe der Erdalkalimetalle wie z.B. Ba zu wählen. Neben Y für Me1 und Ba für Me2 geeignete Materialien sind allgemein bekannt. Dabei sollen die entsprechenden metallischen Komponenten des Stoffsystems Me1-Me2-Cu-O jeweils mindestens ein (chemisches) Element aus den genannten Gruppen enthalten oder jeweils aus diesem mindestens einen Element bestehen. Me1 und Me2 können also vorzugsweise Jeweils ein Element sein. Gegebenenfalls sind jedoch auch Legierungen oder Verbindungen oder sonstige Zusammensetzungen dieser Metalle mit Substitutionsmaterialien als Ausgangsstoffe geeignet; d.h., mindestens eines der genannten Elemente kann gegebenenfalls partiell durch ein anderes substituiert sein. Für das Substrat werden insbesondere Materialien gewählt, die eine hinreichende Haftung der supraleitenden Schichten auf ihnen gewährleisten.

Das erfindungsgemäße Verfahren gliedert sich gemäß einer vorteilhaften Ausgestaltung im wesentlichen in vier Verfahrensschritte unter, auf die nachfolgend im einzelnen eingegangen wird. Dabei sei die Herstellung einer Schicht aus dem supraleitenden Hoch-$T_c$-Material $YBa_2Cu_3O_{7-x}$ als Ausführungsbeispiel zugrundegelegt. D.h., für das Stoffsystem Me1-Me2-Cu-O sei Me1 = y und Me2 = Ba gewählt.

1. Verfahrensschritt
(Bereitstellung verdampfbarer Ausgangskomponenten)

Da sich die drei metallischen Ausgangselemente Y, Ba und Cu des gewünschten supraleitenden Materials im Rahmen des Systems Y-Ba-Cu-O insgesamt nur schwer verdampfen lassen, werden als Ausgangsmaterialien verdampfbare Verbindungen dieser Elemente vorgesehen. Von anorganischen Salzen kommen insbesondere Halogenide, beispielsweise Chloride, in Frage. Für die entsprechenden Verbindungen mit den einzelnen Ausgangselementen ist jeweils ein realistisch anzusehender Partialdruck von etwa 1 Torr bei ungefähr den folgenden Temperaturen zu erwarten:

CuCl: 600 °C,
$YCl_3$: 950 °C,
$BaCl_2$: 1100 °C.

Ein mit Chloriden als Ausgangsverbindungen arbeitendes Verfahren müßte demnach bei verhältnismäßig hohen Temperaturen von mindestens 1100 °C (Verdampfungstemperatur des $BaCl_2$) betrieben werden.

Es sind auch organische Verbindungen der Ausgangsmetalle an sich bekannt, die sich vorteilhaft für das erfindungsgemäße Verfahren als Ausgangsverbindungen verwenden lassen. Dies sind insbesondere β-Diketon-Chelate, deren auffällige Merkmale die Löslichkeit in organischen Solventien und die Verdampfbarkeit sind. β-Diketone haben die Eigenschaft, auch in einer Enolform aufzutreten, die mit Metallionen salzartige Chelate bildet:

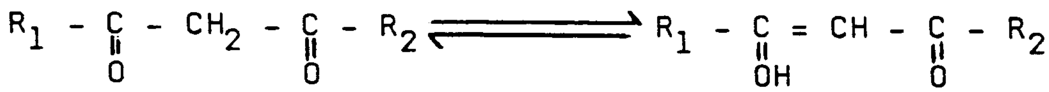

Ketoform Enolform

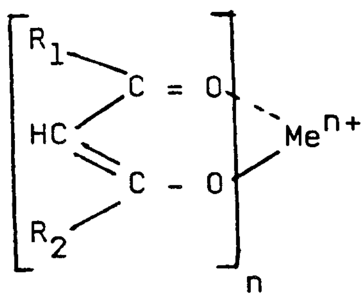

Chelat

β-Diketonate sind ausführlich untersucht mit Blick auf Lösungsextraktion, Gas-Flüssig-Chromatographie, Kernresonanz-Verfahren, Lasertechnologie und Polymer-Fabrikation (vgl. z.B. R.C.Mehrotra, R.Bohra, D.P.Gaur: "Metal β-Diketonates and Allied Derivates", Academic Press, London - New York - San Francisco, 1978). Wo eine Chelat-Bildung nicht möglich ist - dies ist insbesondere für Nb, Bi, Tc, W und Re der Fall (vgl. das vorstehend genannte Buch von R.C.Mehrotra et.al.) -, kann z.B. der erwähnte Weg über Halogenide beschritten werden. Die metallischen Komponenten des als Ausführungsbeispiel gewählten Stoffsystems Y-Ba-Cu-O bilden jedoch alle Chelate:
Für das erfindungsgemäße Verfahren sind insbesondere das Kupfer-Chelat $Cu(C_5H_7O_2)_2$ sowie die Y- und Ba-Chelate $Y(C_{11}H_{19}O_2)_3$ bzw. $Ba(C_{11}H_{19}O_2)$ von 2,2,6,6-Tetramethyl-heptan-3,5-dion (vgl. z.B. "Gmelin Handbook of Inorganic Chemistry", System Number 39, Part D3, Springer Verlag 1981, Seiten 125 bis 135) zu verwenden. Das Kupfer-Chelat ist im Handel zu erhalten, die beiden anderen Ausgangsverbindungen lassen sich aus Tetramethyl-heptan-dion und Y- bzw. Ba-Salzen herstellen (vgl. z.B. "Journal of the American Chemical Society", Vol.87, No. 22, Nov. 1965, Seiten 5254 bis 5256; "Journal of Inorganic and Nuclear Chemistry", Vol. 29, 1967, Seiten 1931 bis 1936; G.S.Hammond, D.C.Nonhebel, C.-H.S.Wu: "Inorganic Chemistry" Vol. 2, 1963, Seiten 73 bis 76).

2. Verfahrensschritt
(Verdampfen und Dosieren)

In diesem Verfahrensschritt werden als Ausgangsmaterialien die gemäß dem ersten Verfahrensschritt ausgewählten drei Ausgangsverbindungen der drei metallischen Ausgangselemente Y, Ba und Cu jeweils bei einer vorbestimmten Temperatur $T_1$ bzw. $T_2$ bzw. $T_3$ in einer Verdampfungskammer verdampft. Die zu wählenden Temperaturen sind dabei, abgesehen von den jeweiligen Verdampfungstemperaturen, von den erforderlichen Partialdrücken der verwendeten Ausgangsverbindungen festgelegt. Gemäß dem in Figur 1 gezeigten Schema für eine erfindungsgemäße Abscheidung einer supraleitenden Hoch-$T_c$-Oxidkeramikdes Stoffsystems Y-Ba-Cu-O mittels einer chemischen Gasphasenreaktion werden die Dämpfe der drei Ausgangsverbindungen in den Verdampfungskammern 2a bis 2c jeweils einem Trägergasstrom 3a bis 3c, z.B. aus Argon, zugemischt. Diese Zumischungen müssen so dosiert werden, daß bei einem anschließenden Zusammenführen der drei so entstandenen Dampfströme 4a bis 4c zu einem Dampfgemisch 5 in einem Mischbereich 6, z.B. einer entsprechenden Mischkammer, ein bestimmtes Verhältnis der drei metallischen Ausgangselemente zumindest annähernd eingehalten wird. Dieses Verhältnis hängt vom Grad der Umsetzung der Ausgangselemente bei einer abschließenden Reaktion unter Ausbildung und Abscheidung des gewünschten Supraleitermaterials ab. Bei vollständiger Umsetzung kann dieses Verhältnis in etwa dem stöchiometrischen Verhältnis der Ausgangselemente in dem Supraleitermaterial entsprechen. Dieses Dosieren ist bei dem erfindungsgemäßen Verfahren mit mehreren Komponenten, deren Eigenschaften empfindlich von der prozentualen Zusammensetzung abhängen, entscheidend. Es ist deshalb unerläßlich, daß für den zweiten Verfahrensschritt der Dampfdruck der verwendeten Ausgangsverbindungen in Abhängigkeit von der Temperatur berücksichtigt wird. Die entsprechenden Daten sind entweder bekannt oder lassen sich ohne weiteres experimentell ermitteln. In Figur 2 sind in einem Diagramm die entsprechenden Dampfdruckkurven p in Abhängigkeit von der Temperatur T für die Ausgangsverbindungen CuCl, $YCl_3$ und $BaCl_2$ angegeben. Entsprechende Kurven lassen sich auch für die dem Ausführungsbeispiel zugrundegelegten Diketonate der drei metallischen Ausgangselemente ermitteln. In Figur 3 sind die Dampfdruckkurven p für $\beta$-Diketonate von Ba, Cu und Y in Figur 2 weitgehend entsprechender Darstellung wiedergegeben, wobei auf der unteren Abszisse der reziproke Wert der Temperatur als I/T, aufgetragen ist. Die zugehörigen T-Werte (in °C) sind aus der oberen Abszisse ersichtlich. So werden z.B. für das $(C_5H_7O_2)_2Cu$ in Gegenwart von Argon 1 Torr bei etwa 186°C und 10 Torr bei etwa 225°C gefunden.

Gemäß dem angenommenen Ausführungsbeispiel wird das Argon über ein Gasmeßgerät durch ein mit konstanter Temperaturzone beheiztes Glasrohr geleitet, das eine lockere Schüttung der zu verdampfenden Substanz aus einem Diketonat-Quarzwolle-Gemisch enthält. Man kann z.B. in den Verdampfergefäßen Temperaturen $T_1$, $T_2$ $T_3$ einstellen, bei denen die aus den Dampfdruck-Temperatur-Kurven zu entnehmenden Partialdrucke der Komponenten gleich sind. Diese Temperaturen liegen z.B. in einem Temperaturbereich zwischen 150°C und 300°C. Für ein Molverhältnis der Diketonate von Y, Ba und Cu im Reaktionsgasgemisch 11 von 1:2:3 werden dann Trägergasströme mit Flüssen im gleichen Verhältnis 1:2:3, gemessen in l/sec, vorgesehen.

3. Verfahrensschritt
(Komplettierung mit einer reaktionsfähigen Komponente)

Gemäß dem in Figur 1 gezeigten Reaktionsschema wird in dem dritten Verfahrensschritt in einem Bereich 7 mindestens eine weitere, dampf- und/oder gasförmige Komponente beigemischt. Diese mindestens eine Komponente ist dabei so ausgewählt, daß sie eine Umsetzung mit den verdampften Ausgangsverbindungen unter Ausbildung bzw. Abscheidung der gewünschten supraleitenden Hoch-$T_c$-Oxidkeramik erlaubt. Im Falle der als Ausführungsbeispiel gewählten Diketonate der Ausgangselemente Y, Ba und Cu wären dies Wasserdampf und/oder Sauerstoff. Eine einstellbare Sauerstoffbeimischung ist nämlich im Hinblick auf die angestrebte Ausbildung des Supraleitermaterials besonders vorteilhaft. Bei PVD-Verfahren ist eine entsprechende Sauerstoffbeigabe hingegen nicht möglich.

Der oder die Reaktionspartner wird (werden) in einer Kammer 8 ebenfalls dosiert einem Trägergasstrom 9 wie z.B. aus Argon beigefügt. Das so entstandene Dampf-/Gas-Gemisch sei nachfolgend als "Reaktionskomponente" 10 bezeichnet. Die Beimischung dieser Reaktionskomponente zu dem Dampfgemisch 5 in dem Bereich 7 soll dabei unter Zumischbedingungen erfolgen, bei denen noch keine wesentliche Reaktion mit den dampfförmigen Ausgangsverbindungen eintritt. Es ergibt sich somit ein in Figur 1 mit 11 bezeichnetes Reaktionsgas- bzw. -dampfgemisch. Dieses Reaktionsgasgemisch setzt sich gemäß dem gewählten Ausführungsbeispiel aus den verdampften Diketonaten der metallischen Ausgangselemente Y, Ba und Cu, dem $O_2$-Gas und $H_2O$-Dampf der Reaktionskomponente sowie dem Trägergas Argon zusammen. Die Konzentrationswerte der Diketonate im Reaktionsgasgemisch 11, die die Zusammensetzung der abzuscheidenden supraleitenden Hoch-$T_c$-Oxidkeramik in jedem Fall, auch bei nur teilweiser, aber reproduzierbarer Umsetzung, bestimmen, werden über den Partialdruck bei vorgegebener Temperatur und kontrolliertem Trägergasfluß eingestellt.

4. Verfahrensschritt
(Chemische Gasphasenreaktion)

Das Reaktionsgasgemisch 11 wird gemäß Figur 1 schließlich in einen Reaktionsraum 12 geleitet, in dem sich das zu beschichtende Substrat befindet. Dieses Substrat kann beispielsweise in dem Reaktionsraum 12 ortsfest angeordnet sein oder, insbesondere im Fall einer kontinuierlichen Beschichtung von z.B. bandförmigen Substraten, kontinuierlich durch diesen Reaktionsraum geführt werden. In diesem Reaktionsraum sind dabei Reaktionsbedingungen erfüllt, die die gewünschte Umsetzung zu der supraleitenden Hoch-$T_c$-Oxidkeramik auf dem Substrat gewährleisten. Hierzu ist das Substrat auf einer vorbestimmten Temperatur $T_4$ zu halten. Gemäß dem gewählten Ausführungsbeispiel sind insbesondere zwei Möglichkeiten gegeben, aus Diketonaten der Ausgangselemente das gewünschte Metalloxid zu erhalten:

1) Thermische Zersetzung (Pyrolyse), mit oder ohne Sauerstoff;

2) Hydrolyse und Dehydratisierung der Hydroxide.

Für eine thermische Zersetzung gemäß Möglichkeit 1) können bekannte Verfahrensabläufe zugrundegelegt werden. So ist z.B. aus J.H.Harward: "Industrial Applications of the Organometallic Compounds", Chapman and Hall 1963, Seiten 336 bis 341 eine Pyrolyse für Kupferacethylacetonat bekannt. Auch aus der US-PS 3 850 665 oder der US-PS 3 645 778 ist eine thermische Zersetzung der Acetylaceton-Chelate von Cu und von weiteren Metallen zu entnehmen.

Besonders vorteilhaft für die Präparation der redox-empfindlichen supraleitenden Oxidkeramik des genannten Stoffsystems sind die Hydrolyse und Dehydratisierung gemäß Möglichkeit 2). Die entsprechende Reaktion, die auch dem in Figur 1 gezeigten Reaktionsschema zugrundegelegt ist, verläuft nach dem nachstehend aufgeführten Reaktionsschema:

$$Me^{n+}(R_1COCHCOR_2)_n + nH_2O \rightarrow Me(OH)_n + nR_1COCH_2COR_2$$
$$Me(OH)_n \rightarrow MeO_{0.5n} + 0.5n\ H_2O$$

Me sind dabei die Ausgangskomponenten Me1, Me2 und Cu.

Sofern die Reaktion durch eine Temperaturerhöhung eingeleitet werden soll, kann die untere Grenze $T_4$ hierfür ungefähr 300 °C betragen. In der Figur 1 ist ferner das sich bei der Reaktion bildende, aus dem Reaktionsraum 12 abzuführende Abgas mit 13 bezeichnet.

Abweichend von dem dargestellten Ausführungsbeispiel kann gegebenenfalls auch eine Kombination vorgesehen werden, bei der eine thermische Zersetzung, eine Hydrolyse und Oxidation gleichzeitig stattfinden. In diesem Fall wären dann während des 3. Verfahrensschrittes dem Dampfgemisch 5 aus den Diketonaten und Argon im Bereich 7 zur Komplettierung noch Wasserdampf und Sauerstoff zuzuführen.

Gegebenenfalls ist es sogar möglich, die Beimischung des Reaktionspartners 10 nicht außerhalb des Reaktionsraumes 12 in dem Bereich 7 vorzunehmen, sondern die Reaktionskomponenten wie z.B. $H_2O$ und $O_2$ direkt mittels eines Trägergasstromes in dem Reaktionsraum einzuleiten.

Gemäß dem Verfahrensschema nach Figur 1 wurde für die Abscheidung des gewünschten supraleitenden Hoch-$T_c$-Metalloxides von Diketonaten der metallischen Ausgangselemente ausgegangen. Das dargestellte Verfahren ist insbesondere dann geeignet, wenn verhältnismäßig niedrige Reaktionstemperaturen $T_4$ von beispielsweise über 300 °C vorgesehen werden sollen. Sind hingegen höhere Reaktionstemperaturen tolerierbar, so kann man auch von Halogeniden, insbesondere Chloriden der Ausgangselemente ausgehen. Ein diesbezügliches Verfahrensschema ist in Figur 4 in einer Figur 1 entsprechenden Darstellung skizziert. Auch bei diesem Verfahren besteht die in der Figur durch einen Sperrhahn nur angedeutete Möglichkeit, zunächst erst das Dampfgemisch aus den Chloriden der Ausgangselemente und dem Trägergas in den Reaktionsraum einzuleiten und erst dann den mindestens einen reaktionsfähigen Partner ($O_2$, $H_2O$, mit Trägergas Ar) zuzuführen.

Bei den als Ausführungsbeispielen geschilderten Verfahren zur Herstellung bzw. Abscheidung mindestens einer supraleitenden Schicht des Stoffsystems Me1-Me2-Cu-O auf einem erhitzten Substrat wurde gemäß Verfahrensschritt 3 die als vorteilhaft anzusehende Beimischung mindestens eines reaktionsfähigen Partners ($O_2$, $H_2O$) vorausgesetzt. Eine derartige Beimischung ist jedoch nicht in jedem Falle unbedingt erforderlich. So können z.B. auch verdampfbare Ausgangsverbindungen gewählt werden, die allein durch Pyrolyse in dem Reaktionsraum 12 eine Ausbildung des gewünschten Supraleitermaterials ermöglichen. Sind diese Ausgangsverbindungen $O_2$-haltig, so kann man gegebenenfalls bei dem Abscheideprozeß sogar auf eine besondere $O_2$-Zufuhr verzichten.

Neben der erwähnten Temperaturerhöhung als Energiezufuhr zur Einleitung der gewünschten Reaktion zur Ausbildung bzw. Abscheidung des Supraleitermaterials in dem Reaktionsraum sind ebensogut auch andere bekannte Arten der Energiezufuhr, z.B. mittels eines Lasers, für das erfindungsgemäße Verfahren geeignet.

## Patentansprüche

**1.** Verfahren zur Abscheidung mindestens einer Schicht aus einem oxidkeramischen Supraleitermaterial eines metallische Komponenten und Sauerstoff enthaltenden Stoffsystems mit hoher Sprungtemperatur auf einem Substrat,
**gekennzeichnet** durch die folgenden Verfahrensschritte:
a) Als Ausgangsmaterialien werden von jeder der metallischen Komponenten des Stoffsystems ein verdampfbares Chelat, insbesondere $\beta$-Diketonat, oder ein verdampfbares Halogenid vorgesehen,
b) jede dieser verdampfbaren Verbindungen wird bei einer vorbestimmten Temperatur ($T_1$ bis $T_3$) und einem vorbestimmten Partialdruck verdampft und mittels eines Trägergasstromes (3a bis 3c) so dosiert, daß bei dem anschließenden Zusammenführen der drei so gebildeten Dampfströme (4a bis 4c) zu einem Dampfgemisch (5) ein Verhältnis der metallischen Komponenten eingestellt wird, wie es zur Ausbildung des Supraleitermaterials benötigt wird,
und
c) zur Abscheidung des gewünschten Supraleitermaterials werden die Reaktionsbedingungen für eine Reaktion der oder mit den dampfförmigen Ausgangsverbindungen durch Energiezufuhr eingestellt, wobei die Reaktion der oder mit den Ausgangsverbindungen

α) entweder in Form einer thermischen Zersetzung der Ausgangsverbindungen

β) oder durch Hydrolyse der Ausgangsverbindungen und Dehydratisierung der dabei gewonnenen Hydroxide

vorgenommen wird.

2. Verfahren nach Anspruch 1, **dadurch gekennzeichnet,** daß im Fall der Reaktion in Form einer thermischen Zersetzung die Reaktion unter Sauerstoffzufuhr erfolgt.

3. Verfahren nach Anspruch 1 oder 2, **dadurch gekennzeichnet,** daß dem Dampfgemisch (5) mittels eines Trägergases (9) mindestens ein weiterer dampf- oder gasförmiger reaktionsfähiger Partner zugeführt wird, der mit den dampfförmigen Ausgangsverbindungen unter Bildung des Supraleitermaterials reagieren kann.

4. Verfahren nach Anspruch 3, **dadurch gekennzeichnet,** daß der reaktionsfähige Partner unter Zumischbedingungen zugeführt wird, die keine wesentliche Reaktion mit den dampfförmigen Ausgangsverbindungen bewirken.

5. Verfahren nach Anspruch 3 oder 4, **dadurch gekennzeichnet,** daß dem Dampfgemisch (5) aus den drei die Ausgangsverbindungen enthaltenden Dampfströmen (4a bis 4c) als reaktionsfähiger Partner Wasserdampf zugeführt wird.

6. Verfahren nach einem der Ansprüche 3 bis 5, **dadurch gekennzeichnet,** daß dem Dampfgemisch (5) aus den drei die Ausgangsverbindungen enthaltenden Dampfströmen (4a bis 4c) als reaktionsfähiger Partner Sauerstoff-Gas zugeführt wird.

7. Verfahren nach einem der Ansprüche 1 bis 6, **dadurch gekennzeichnet,** daß bei dem Zusammenführen der drei Dampfströme (4a bis 4c) zu dem Dampfgemisch (5) ein vorbestimmtes Verhältnis der metallischen Komponenten derart eingestellt wird, daß das stöchiometrische Verhältnis dieser Komponenten in dem Supraleitermaterial mit der hohen Sprungtemperatur zumindest weitgehend erhalten wird.

8. Verfahren nach einem der Ansprüche 1 bis 7, **dadurch gekennzeichnet,** daß die Reaktion der oder mit den Ausgangskomponenten zur Abscheidung des Supraleitermaterials mittels Temperaturerhöhung eingeleitet wird.

9. Verfahren nach einem der Ansprüche 1 bis 8, **dadurch gekennzeichnet,** daß zur Abscheidung des Supraleitermaterials das Substrat auf einer Temperatur zwischen 300 und 900 °C gehalten wird.

10. Verfahren nach einem der Ansprüche 1 bis 9, **dadurch gekennzeichnet,** daß Argon als Trägergas (3a bis 3c, 9) vorgesehen wird.

11. Verfahren nach einem der Ansprüche 1 bis 10, **dadurch gekennzeichnet,** daß ein oxidkeramisches Supraleitermaterial auf Basis des Stoffsystems Me1-Me2-Cu-O vorgesehen wird, wobei die metallischen Komponenten Me1 und Me2 ein Seltenes Erdmetall (einschließlich Yttrium) bzw. ein Erdalkalimetall zumindest enthalten.

12. Verfahren nach Anspruch 11, **dadurch gekennzeichnet,** daß Komponenten Me1 und Me2 vorgesehen werden, die Yttrium (Y) bzw. Barium (Ba) zumindest enthalten.

## Claims

1. A process for depositing on a substrate at least one layer of a high critical temperature ceramic oxide superconductor comprising a material system containing metal constituents and oxygen, characterised by the following process steps:

a) as starting materials, a vaporizable chelate, in particular β-diketonate, or a vaporizable halide is provided by each of the metal constituents of the system of substances,

b) each of these vaporizable compounds is vaporized at a predetermined temperature ($T_1$ to $T_3$) and a pre-determined partial pressure, and dosed by means of a carrier gas stream (3a to 3c) so that, when the three vapour streams (4a to 4c) formed in this way are subsequently brought together to form a vapour mixture (5), a ratio of metal constituents is adjusted as required for formation of the superconductor material,

and

c) for depositing the desired superconducting material, the reaction conditions for a reaction of or with the vaporous starting compounds, are adjusted by means of the energy supply, the reaction of or with the starting compounds being carried out as follows:

$\alpha$) either in the form of a thermal decomposition of the starting compounds,

$\beta$) or by means of hydrolysis of the starting compounds and dehydration of the hydroxides thus obtained.

2. A process according to claim 1, characterised in that, where the reaction is in the form of a thermal decomposition, the reaction takes place under an oxygen supply.

3. A process according to claim 1 or 2, characterised in that there is supplied to the vapour mixture (5), by means of a carrier gas (9), at least one further vaporous or gaseous reagent which can react with the vaporous starting compounds during the formation of the superconducting material.

4. A process according to claim 3, characterised in that the reagent is supplied under conditions of addition which produce no substantial reaction with the vaporous starting compounds.

5. A process according to claims 3 or 4, characterised in that water vapour is supplied as the reagent to the vapour mixture (5) comprised by the three vapour streams (4a to 4c) containing the starting compounds.

6. A process according to one of claims 3 to 5, characterised in that oxygen gas is supplied as the reagent to the vapour mixture (5) comprised by the three vapour streams (4a to 4c) containing the starting compounds.

7. A process according to one of claims 1 to 6, characterised in that, when the three vapour streams (4a to 4c) are brought together to form the vapour mixture (5), a predetermined ratio of metal constituents is established in such a way that the stoichiometric ratio of these constituents is at least substantially maintained in the high critical temperature superconducting material.

8. A process according to one of claims 1 to 7, characterised in that the reaction of or with the starting constituents for depositing the superconducting material is initiated by means of an increase in temperature.

9. A process according to one of claims 1 to 8, characterised in that, for depositing the superconducting material, the substrate is maintained at a temperature between 300 and 900 °C.

10. A process according to one of claims 1 to 9, characterised in that argon is provided as the carrier gas (3a to 3c, 9).

11. A process according to one of claims 1 to 10, characterised in that there is provided a ceramic oxide superconductor based on the material system Me1-Me2-Cu-O, the metal constituents Me1 and Me2 respectively containing at least one of the rare earth metal (which include yttrium) and one alkaline earth metal.

12. A process according to claim 11, characterised in that there are provided constituents Me1 and Me2 which respectively contain at least yttrium (Y) and barium (Ba).

## Revendications

1. Procédé pour déposer au moins une couche d'un matériau supraconducteur en oxyde céramique d'un système de matières contenant des composants métalliques et de l'oxygène avec une température de

transition de conductivité élevée sur un substrat, caractérisé par les étapes de procédé suivantes :

a) on utilise comme matières premières de chacun des composants métalliques du système de matières un chélate vaporisable et, en particulier, un β-dicétonate ou un halogénure vaporisable,

b) chacun de ces composés vaporisables est vaporisé à une température prédéterminée ($T_1$ à $T_3$) et sous une pression partielle prédéterminée et est dosé au moyen d'un courant de gaz porteur (3a à 3c) de façon que, au moment de la combinaison ultérieure des trois courants de vapeur ainsi formés (4a à 4c)pour former un mélange de vapeur (5), on obtient un rapport des composants métalliques nécessaires pour former le matériau supraconducteur, et

c) pour déposer le matériau supraconducteur recherché, les conditions de réaction pour une réaction des ou avec les composés de départ sous forme de vapeur sont obtenues par un apport d'énergie, la réaction des ou avec les composés de départ étant effectuée

α) soit sous forme d'une décomposition thermique des composés de départ,

β) soit par hydrolyse des composés de départ et déshydratation des hydroxydes ainsi formés.

**2.** Procédé selon la revendication 1, caractérisé en ce que, dans le cas de la réaction en forme d'une décomposition thermique, la réaction a lieu avec apport d'oxygène.

**3.** Procédé selon la revendication 1 ou 2, caractérisé en ce qu'on amène au mélange de vapeur (5) au moyen d'un gaz porteur (9) au moins un autre partenaire réactif à l'état de gaz ou de vapeur qui peut réagir avec les composés de départ à l'état de vapeur en formant le matériau supraconducteur.

**4.** Procédé selon la revendication 3, caractérisé en ce que le partenaire réactif est amené dans des conditions de mélange qui ne provoquent pas de réaction notable avec les composés de départ à l'état de vapeur.

**5.** Procédé selon la revendication 3 ou 4, caractérisé en ce qu'on ajoute au mélange de vapeur (5) formé des trois courants de vapeur (4a à 4c) contenant les composés de départ, de la vapeur d'eau comme partenaire réactif.

**6.** Procédé selon l'une des revendications 3 à 5, caractérisé en ce que l'on ajoute au mélange de vapeur (5) formé des trois courants de vapeur(4a à 4c) contenant les composés de départ, de l'oxygène gazeux comme partenaire réactif.

**7.** Procédé selon l'une des revendications 1 à 6, caractérisé en ce que, lors de la réunion des trois courants de vapeur (4a à 4c) pour former un mélange de vapeur (5), on réalise un rapport prédéterminé, des composants métalliques de façon que le rapport stoechiométrique de ces composants dans le matériau supraconducteur ayant une température de transition de conductivité élevée soit obtenu au moins dans une large mesure.

**8.** Procédé selon l'une des revendications 1 à 7, caractérisé en ce que la réaction des ou avec les composants de départ pour déposer le matériau supraconducteur est provoquée par une augmentation de la température.

**9.** Procédé selon l'une des revendications 1 à 8, caractérisé en ce que, pour déposer le matériau supraconducteur, le substrat est maintenu à une température comprise entre 300 et 900 °C.

**10.** Procédé selon l'une des revendications 1 à 9, caractérisé en ce que l'argon est prévu comme gaz porteur (3a à 3c, 9).

**11.** Procédé selon l'une des revendications 1 à 10, caractérisé en ce qu'il est prévu un matériau supraconducteur d'oxyde céramique à base du système de matières Me1-Me2-Cu-O, dans lequel les composants métalliques Me1 et Me2 contiennent au moins un métal des terres rares (y compris l'yttrium) ou un métal alcalino-terreux.

**12.** Procédé selon la revendication 11, caractérisé en ce que les composants Me1 et Me2 prévus contiennent au moins de l'yttrium (Y) respectivement du baryum (Ba).

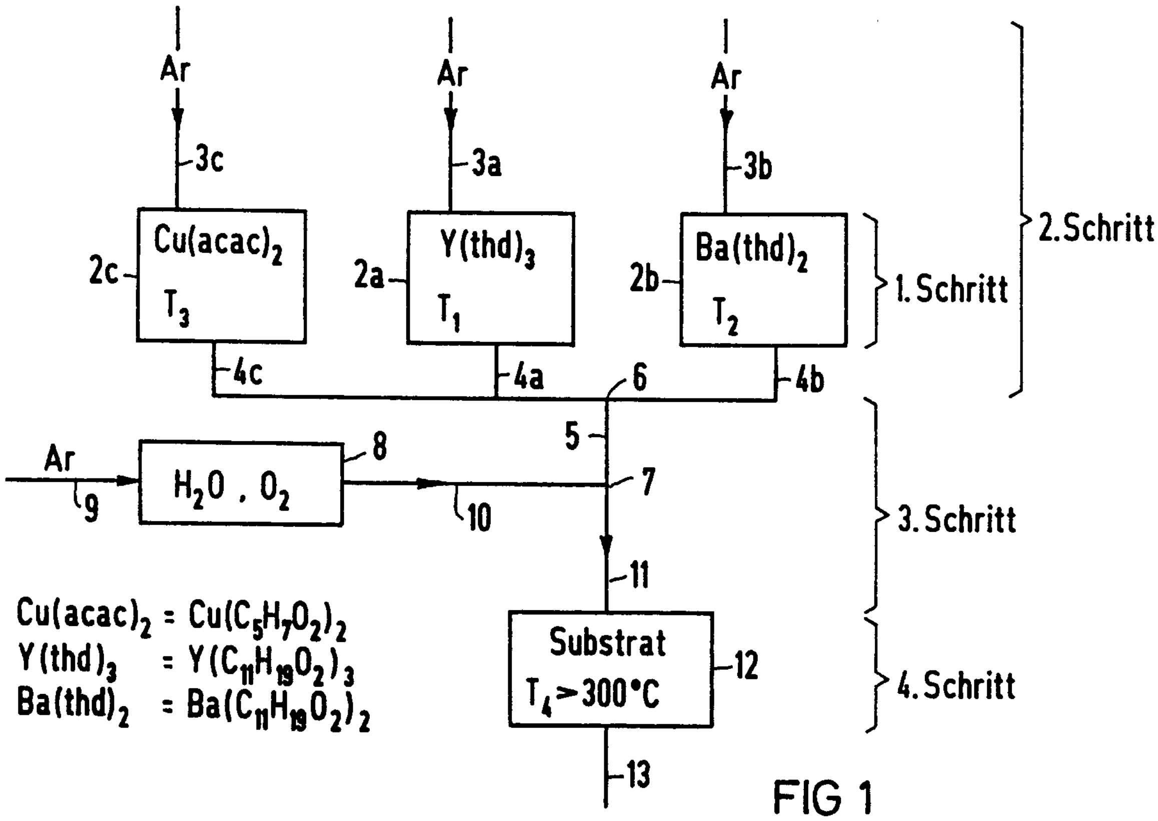
Ar
Ar
Ar
3c
3a
3b
Cu(acac)$_2$
$T_3$
2c
Y(thd)$_3$
$T_1$
2a
Ba(thd)$_2$
$T_2$
2b
1. Schritt
2. Schritt
4c
4a
6
4b
Ar
9
$H_2O$ , $O_2$
8
5
7
10
3. Schritt
11
Cu(acac)$_2$ = $Cu(C_5H_7O_2)_2$
Y(thd)$_3$ = $Y(C_{11}H_{19}O_2)_3$
Ba(thd)$_2$ = $Ba(C_{11}H_{19}O_2)_2$
Substrat
$T_4 > 300°C$
12
4. Schritt
13

FIG 1

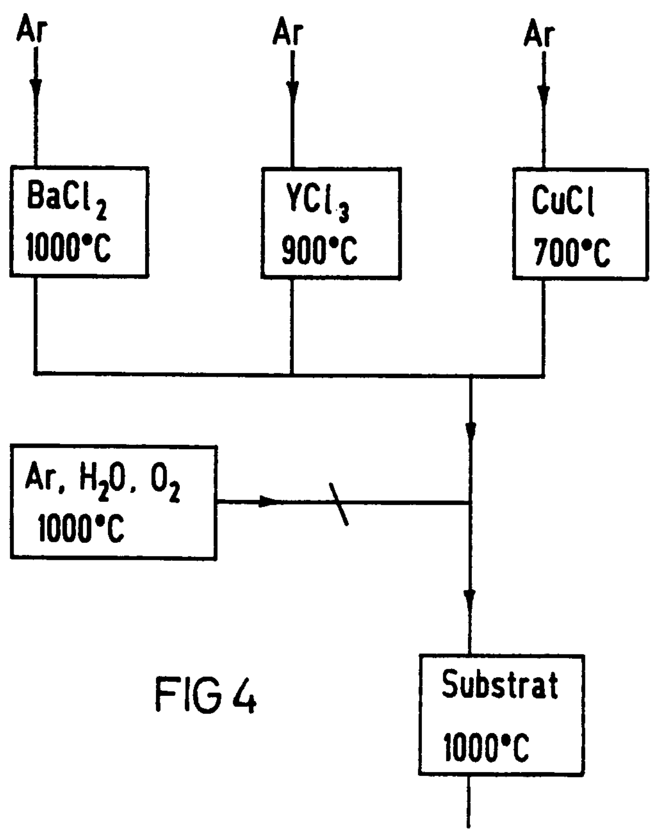
Ar
Ar
Ar
$BaCl_2$
1000°C
$YCl_3$
900°C
CuCl
700°C
Ar, $H_2O$, $O_2$
1000°C
Substrat
1000°C

FIG 4

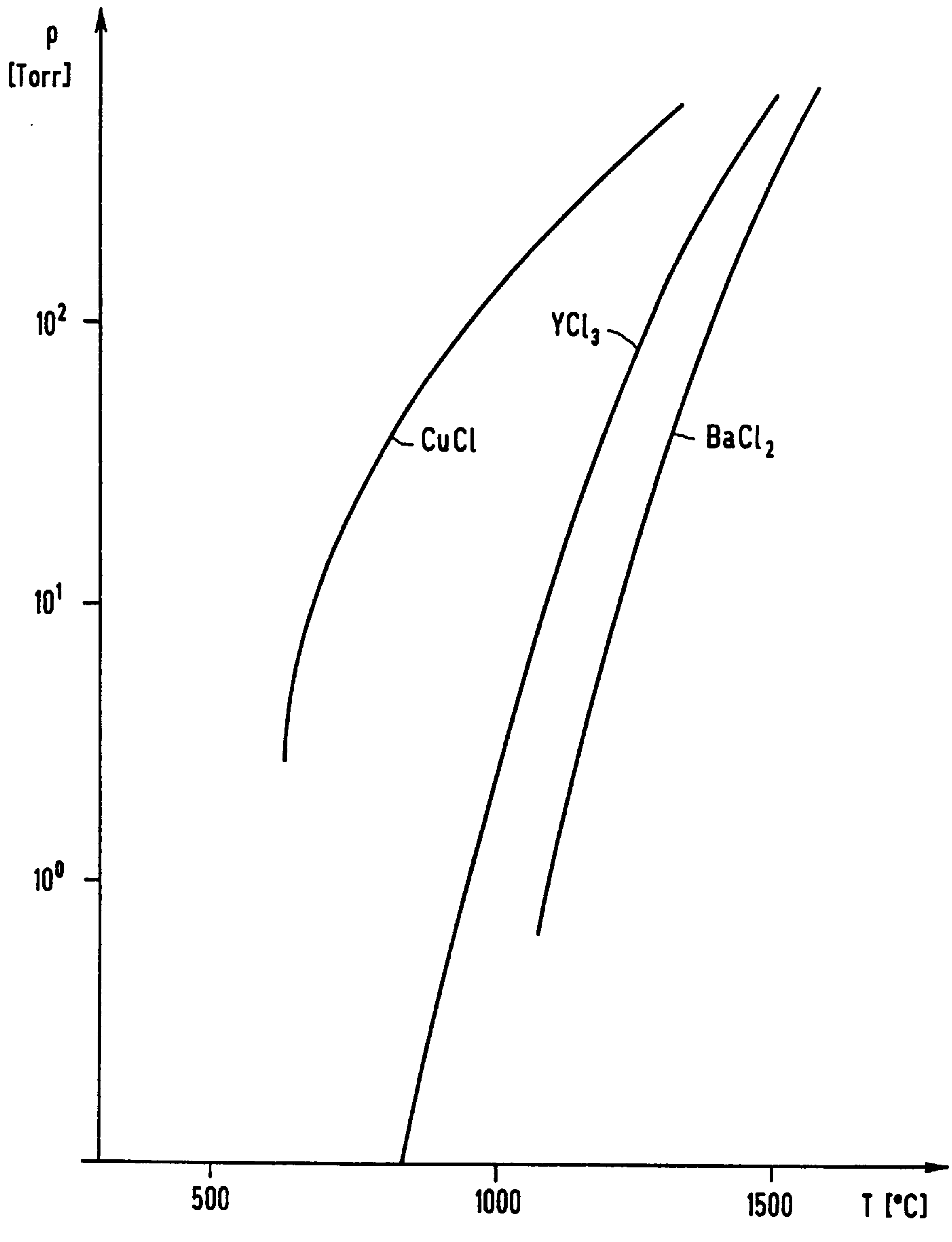


FIG 2

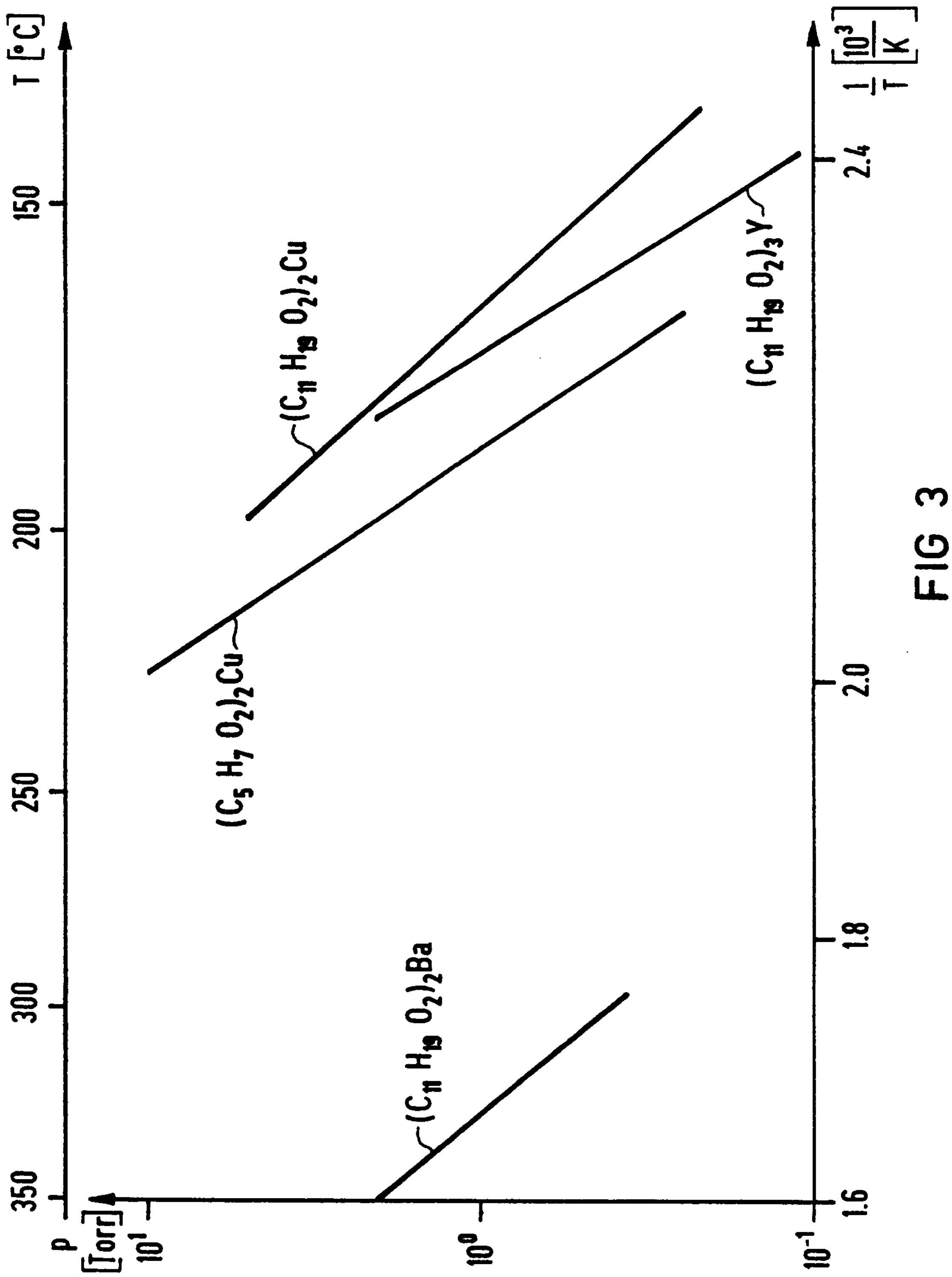
T [°C]
350
300
250
200
150
p [Torr]
$10^1$
$10^0$
$10^{-1}$
1.6
1.8
2.0
2.4
$\frac{1}{T}$ $[\frac{10^3}{K}]$
$(C_{11}H_{19}O_2)_2Ba$
$(C_5H_7O_2)_2Cu$
$(C_{11}H_{19}O_2)_2Cu$
$(C_{11}H_{19}O_2)_3Y$

FIG 3